# EUROPÄISCHE PATENTSCHRIFT

(11) **EP 1 370 125 B1**
(45) Veröffentlichungstag und Bekanntmachung des Hinweises auf die Patenterteilung: **21.03.2007**
(21) Anmeldenummer: 03012410.1
(22) Anmeldetag: 30.05.2003
(51) Int. Cl.: H05K 7/20

(54) **Luftdurchtrittseinrichtung**
Device for the passage of air
Dispositif d'aération

(30) Priorität: 03.06.2002 DE 20208609 U; 28.05.2003 DE 20308482 U
(43) Veröffentlichungstag der Anmeldung: 10.12.2003
(73) Patentinhaber: Pfannenberg GmbH, 21035 Hamburg (DE)
(72) Erfinder: Pfannenberg, Andreas, 21035 Hamburg (DE)
(74) Vertreter: Richter, Werdermann, Gerbaulet & Hofmann

(56) Entgegenhaltungen:
- US-A- 6 110 245
- US-B1- 6 171 357
- US-B1- 6 272 022

## Beschreibung

Die Erfindung betrifft eine Luftdurchtrittseinrichtung, insbesondere Filterlüfter oder Austrittsfilter gemäß dem Oberbegriff des Anspruches 1.

Bei in einem Gehäuse angeordneten Bauteilen, welche entsprechende Abwärme erzeugen, ist es notwendig, die Abwärme aus dem Gehäuse abzuführen und eine Temperatur in dem Gehäuse durch mehr oder weniger starkes Einblasen oder Absaugen von Umgebungsluft in den Gehäuseinnenraum mittels des Lüfters zu kontrollieren. Ein bekanntes Beispiel hierfür sind Computergehäuse. Üblicherweise werden derartige Gehäuse mit einem Filterlüfter versehen, welcher entweder ständig läuft oder von einer Steuerung in Abhängigkeit von einer Temperatur im Gehäuse an- und abgeschaltet wird. Der Filterlüfter ist in einer Ausnehmung einer Wandung des Gehäuses angeordnet und beispielsweise mittels Schraubverbindungen fixiert. Gleichzeitig sind an einer anderen Stelle des Gehäuses für einen Luftaustritt entsprechende Luftaustrittsschlitze vorgesehen. Die Montage derartiger Filterlüfter ist jedoch oftmals mühevoll, da bei der Anwendung von Schraubverbindungen kaum Spielraum zur Verfügung steht, um den Filterlüfter auch noch nachträglich optisch ausrichten zu können.

Durch die US-A-6 110 245 ist ein Filterlüfter zum Einbau in die Wand eines Schaltschrankes bekannt, wobei die Einbauwand mit einem Ausschnitt für den Filterlüfter versehen ist, in dem der Filterlüfter gehalten und befestigt ist. Der Filterlüfter besteht aus einem rahmenartigen Grundgehäuse mit einem Gitterboden, einer Filtermatte, die in das Abdeckgehäuse eingesetzt ist, das auf das Grundgehäuse montiert wird und die Filtermatte abdeckt, und aus einem Ventilatormotor, der an dem Grundgehäuse befestigt ist, wobei das Grundgehäuse auf einem Umfang mit einer schraubenlosen Schnellbefestigungsvorrichtung zur Montage des Filterlüfters in dem Ausschnitt der Einbauwand versehen ist, wobei der Filterlüfter, um derart installiert werden zu können, dass er HF-dicht ist, mit einem mit dem Grundgehäuse verbundenen Metalleinsatz versehen ist, der aus einem Rahmen mit einem Gitterboden besteht und der durch Schraub-, Niet- oder Klammermittel mit dem Grundgehäuse verbunden ist. Ein derart ausgebildeter Filterlüfter ist HF-dicht in die Durchbrechung einer Montagewand vermittels einer Schnellmontage einbaubar. Die HF-Dichtigkeit wird mittels eines EMV-Dichtbandes erreicht. Bei der Montage des Filterlüfters wird dessen Grundrahmen mit dem Metalleinsatz verbunden. Anschließend wird diese Baugruppe mit dem EMV-Dichtband beklebt. Dabei muss in den Eckbereichen überlappend geklebt werden, da sonst die erforderliche HF-Dichtigkeit nicht erreicht wird. Die Anbringung des EMV-Dichtbandes ist sorgfältig durchzuführen; sie ist arbeitsintensiv und zeitaufwendig. Für die Befestigung des HF-Dichtbandes ist dieses mit einer Klebemittelbeschichtung versehen. Ist das EMV-Dichtband nicht flächendeckend aufgeklebt, kann es zu Kontaktschwierigkeiten zwischen den am Dichtband ausgebildeten Kontaktzungen und der Montagewand kommen; die dabei herzustellende elektrisch leitfähige Verbindung kann dabei unterbrochen sein.

Aufgabe der vorliegenden Erfindung ist es, eine Luftdurchtrittseinrichtung als Filterlüfter oder als Austrittsfilter gemäß der eingangs beschriebenen Art mit einer verbesserten Schirmwirkung bei hoher Funktionsgewährleistung einer elektrisch leitfähigen Verbindung zwischen einem EMV-Schirmblech und Montageausschnitt eines Schaltschrankes und im Hinblick auf eine EMV-Festigkeit in Verbindung mit einer hohen IP-Schutzart zu schaffen. Des weiteren soll eine Ausschnittskompatibilität gegenüber den bekannten bisher eingesetzten Filterlüftern und eine einfache, kostengünstige Montage sowie Herstellung erreicht werden.

Gelöst wird diese Aufgabe mit einer Luftdurchtrittseinrichtung gemäß der eingangs genannten Art mit den in Anspruch 1 angegebenen Merkmalen.

Danach umfasst die erfindungsgemäße Luftdurchtrittseinrichtung
- ein Lüftungsgitter, das aus einem Rahmen mit einer mit Lamellen und/oder Luftschlitzen versehenen Frontplatte und einer halsartigen Einziehung besteht, wobei der Rahmen ein Filtermedium aufnimmt,
- einen Trägerkörper, der aus einem Rahmen mit einer vorzugsweise keilförmig sich nach außen erweiternden umlaufenden Wandfläche und mit einem Innenraum zur Aufnahme der halsartigen Einziehung des Lüftungsgitters besteht, wobei der Trägerkörper an seiner dem Lüftungsgitter abgewandten Seite mit Luftdurchtrittsöffnungen und mit Wasserableitstegen oder einer Rippenformung zum Ableiten von eingedrungenem Spritzwasser und Kondenswasser versehen ist und zur Aufnahme der halsartigen Einziehung des Lüftungsgitters dient,
- ein Schirmgitter mit einer EMV-Dichtung oder mit einem EMV-Schirmblech mit einer Anzahl von federnden Kontaktzungen zur EMV-Dämpfung, das in den Trägerkörper an der dem Lüftungsgitter abgekehrten Seite eingesetzt ist, und das mittels Schraub-, Niet-, Kleb- oder Klemmverbindungen an dem Trägerkörper gehalten wird, und
- eine auf den Trägerkörper aufgeschäumte IP-Dichtung zum Schutz vor Spritz- und Strahlwasser, wobei alle Bauteile der Luftdurchtrittseinrichtung mittels Klemm- oder Schraubverbindungen zusammengehalten sind.

Diese Luftdurchtrittseinrichtung ist einfach herzustellen und mühelos montierbar. Es wird eine sehr gute Schirmwirkung im Hinblick auf eine EMV-Festigkeit in Verbindung mit einer hohen IP-Schutzart erreicht. Ohne Ventilator ist die Luftdurchtrittseinrichtung z. B. bei Schaltschränken als Luft- austrittsfilter einsetzbar. Mit Ventilator wird die Luftdurchtrittseinrichtung als Filterlüfter eingesetzt, insbesondere in Gehäusen von Abwärme erzeugenden Bauteilen. Dabei kann der Ventilator an den Bauteilen der Luftdurchtrittseinrichtung vormontiert sein. Der Ventilator kann dabei ansaugend als auch rausblasend wirken. Die Gesamteinrichtung wird dann von außen an die Schrankwand montiert, wobei die Abmessung der Durchbrechung in der Schrankwand so bemessen sein muss, dass der Ventilator hindurch geschoben werden kann.

Eine abgeschrägte Außenwandfläche des Trägerkörpers erbringt den Vorteil, dass Spritzwasser gut abgeleitet werden kann. Außerdem ermöglicht die abgeschrägte Außenwandfläche das versenkte Anbringen von Befestigungsschrauben, in dem Randbereichausnehmungen ausgebildet sind.

Weitere vorteilhafte Ausgestaltungen sind Gegenstand der Unteransprüche.

So umfasst eine weitere Ausführungsform der Luftdurchtrittseinrichtung
- ein als Designdeckel ausgebildetes Lüftungsgitter, wobei der Designdeckel aus einem Rahmen mit einer mit Lamellen und/oder Luftschlitzen versehenen Frontplatte und einer halsartigen Einziehung besteht,
- ein in den von dem Rahmen begrenzten Raum eingesetztes raumfüllendes Filtermedium,
- einen als Grundgehäuse ausgebildeten Trägerkörper, wobei das Grundgehäuse aus einem Rahmen mit einer umlaufenden Wandfläche und mit einem Innenraum zur Aufnahme der halsartigen Einziehung des Designdeckels besteht, wobei der Trägerkörper an seiner dem Designdeckel abgewandten die Rückwand bildenden Seite mit Luftdurchtrittsöffnungen und an seiner dem Designdeckel zugekehrten Seite mit einer umlaufenden Dichtung versehen ist, sowie mindestens zwei Verriegelungsecken aufweist und
- ein EMV-Schirmblech aus einem Metallrahmen mit einer umlaufenden, in den Eckbereichen Aussparungen für die Verriegelungsecken des Grundgehäuses aufweisenden Seitenwand und mit einer als Schirmgitter ausgebildeten Rückwand, wobei die dem Grundgehäuse zugewandten Randkanten der umlaufenden Seitenwand des Metallrahmens zur Herstellung einer elektrisch leitfähigen Verbindung zwischen dem EMV-Schirmblech und der Montagedurchbrechung eines Schaltschrankes eine Anzahl von federnden Kontaktzungen aufweisen, die aus der von der umlaufenden Seitenwand des Metallrahmens gebildeten Ebene seitlich herausgestellte Endabschnitte aufweisen, wobei die Kontaktzungen an dem Metallrahmen angepunktet oder aus der umlaufenden Seitenwand des Metallrahmens herausgeschnitten sind, umfasst, wobei alle Bauteile der Luftdurchtrittseinrichtung mittels Klemm- oder Schraubverbindungen zusammengehalten sind.

Eine derart ausgebildete Luftdurchtrittseinrichtung ist ebenfalls einfach herzustellen und mühelos montierbar. Es wird eine sehr gute Schirmwirkung im Hinblick auf eine EMV-Festigkeit in Verbindung erreicht. Ohne Ventilator ist die Luftdurchtrittseinrichtung z. B. bei Schaltschränken als Luftaustrittsfilter einsetzbar. Mit Ventilator wird die Luftdurchtrittseinrichtung als Filterlüfter eingesetzt, insbesondere in Gehäusen von Abwärme erzeugenden Bauteilen. Dabei kann der Ventilator an den Bauteilen der Luftdurchtrittseinrichtung vormontiert sein. Der Ventilator kann dabei ansaugend als auch rausblasend wirken. Die Gesamteinrichtung wird dann von außen an die Schrankwand montiert, wobei die Abmessung der Durchbrechung in der Schrankwand so bemessen sein muss, dass der Ventilator hindurch geschoben werden kann.

Durch die besondere Ausgestaltung des EMV-Schirmbleches der umlaufenden Seitenwand des das EMV-Schirmblech bildenden Rahmens ist eine hohe Funktion der Schirmwirkung gewährleistet, da eine gute elektrische leitfähige Verbindung zwischen dem EMV-Schirmblech und dem Montageausschnitt des Schaltschrankes geschaffen wird. Auch bei abweichenden Abmessungen des Montageausschnittes zu den Abmessungen der Luftdurchtrittseinrichtung ist eine gute Kontaktierung gegeben, da sich die federnden Kontaktzungen Abmessungsdifferenzen anpassen.

Ferner wird mit der erfindungsgemäßen Luftdurchtrittseinrichtung eine höhere Schutzart erreicht; eine kostengünstige Herstellung und Montage ist ebenso gegeben, wie eine gute Kontaktierung der federnden Kontaktzungen zur Montagewand des Schaltschrankes. Durch die Vielzahl der am EMV-Schirmblech vorgesehenen Kontaktzungen, die in Leistenform angeordnet sind, ist gewährleistet, dass immer eine Kontaktierung zu den Metallflächen des Schaltschrankes gegeben sind.

Bei der Verwendung der Luftdurchtrittseinrichtung mit einem Ventilator ist mit dem Designdeckel, dem Grundgehäuse und dem EMV-Schirmblech ein Ventilatorgehäuse mit einem Ventilator und gegebenenfalls mit einem außenliegenden Berührungsschutzgitter verbunden.

Die Befestigung der Bauteile der Luftdurchtrittseinrichtung an der Wand des Designdeckels erfolgt mittels Verschraubung oder andersartig ausgebildeter Befestigungsmittel von außen.

Alle Bauteile der Luftdurchtrittseinrichtung bis auf das EMV-Schirmblech bestehen aus einem Kunststoff.

Um Ventilatoren verschiedener Größen in der Luftdurchtrittseinrichtung verwenden zu können, ist nach einer weiteren Ausgestaltung der Erfindung zwischen dem Ventilatorgehäuse mit dem Ventilator und den übrigen Bauteilen der Luftdurchtrittseinrichtung ein adapterartiger Gebläseträger zur Montage von Ventilatorengehäusen mit größeren oder kleineren Abmessungen gegenüber den Bauteilen der Luftdurchtrittseinrichtung angeordnet.

Ein weiterer Vorteil wird mit einer Ausgestaltung der Luftdurchtrittseinrichtung dadurch erreicht, dass das Schirmgitter des EMV-Schirmbleches mit von seinem umlaufenden Rand zur Schirmgittermitte geneigt verlaufende Flächen einer eingezogenen Wölbung versehen ist, so dass ein eingezogener, vertieft ausgebildeter Flächenabschnitt in der Mitte des Schirmgitters ausgebildet wird. Dadurch ist es möglich, Luftdurchtrittseinrichtungen in kompakter Bauweise und in kleinen Abmessungen herzustellen, da z. B. die Ventilatornabe oder Abschnitte des Ventilators in der im Schirmgitter ausgebildeten Vertiefung zu liegen kommen.

Nachstehend wird die Erfindung beispielsweise anhand der beigefügten Zeichnungen näher erläutert. Diese zeigen:
- Fig. 1: eine schaubildliche Explosionsdarstellung der Luftdurchtrittseinrichtung, bestehend aus einem Lüftungsgitter mit dem Filtermedium, einem Trägerkörper für das Lüftungsgitter, einem Schirmgitter mit EMV-Dichtung, einer aufgeschäumten IP-Dichtung und einem Ventilator,
- Fig. 2: eine schaubildliche Explosionsdarstellung der Luftdurchtrittseinrichtung gemäß Fig. 1 mit auseinander gezogenen Bauteilen,
- Fig. 3: eine schaubildliche Explosionsdarstellung der Luftdurchtrittseinrichtung gemäß Fig. 1 mit einem Abschnitt einer Schaltschrankwand mit einer Montagedurchbrechung,
- Fig. 4: eine schaubildliche Explosionsdarstellung der Luftdurchtrittseinrichtung gemäß Fig. 3 von unten,
- Fig. 5: eine schaubildliche Explosionsdarstellung der Luftdurchtrittseinrichtung mit dem Trägerkörper mit montiertem Schirmgitter und mit abgehobenem Lüftungsgitter mit Ventilator,
- Fig. 6: eine schaubildliche Ansicht eines Abschnittes einer Schaltschrankwand mit im Bereich der Montagedurchbrechung angeordnetem Ventilator und zwischen der Schaltschrankwand und dem Ventilator angeordnetem Schirmgitter,
- Fig. 7: eine schaubildliche Ansicht des Trägerkörpers mit aufgesetztem Schirmgitter,
- Fig. 8: eine schaubildliche Explosionsdarstellung der Luftdurchtrittseinrichtung mit an dem Trägerkörper montiertem Schirmgitter mit EMV-Dichtung und mit montiertem Ventilator und mit angehobenem Lüftungsgitter,
- Fig. 9: eine schaubildliche Ansicht eines Abschnittes einer Schaltschrankwand mit im Bereich der Montageöffnung angeordnetem Trägerkörper mit eingesetztem Schirmgitter und eingesetztem Lüftungsgitter,
- Fig. 10: eine schaubildliche Ansicht eines Abschnittes einer Schaltschrankwand mit im Bereich der Montageöffnung angeordnetem Trägerkörper mit eingesetztem Schirmgitter und mit abgehobenem Lüftungsgitter,
- Fig. 11: eine schaubildliche Ansicht einer weiteren Ausführungsform einer Luftdurchtrittseinrichtung, bestehend aus einem Designdeckel mit dem Filtermedium, einem Gehäuse für den Designdeckel, einem EMV-Schirmblech, und einem Ventilatorgehäuse mit einem Ventilator und einem Berührungs-bzw. Griffschutz, von der Ventilatorseite aus,
- Fig. 12: eine schaubildliche Explosionsdarstellung der Luftdurchtrittseinrichtung gemäß Fig. 11, bei auf dem Designdeckel aufgesetztem Gehäuse,
- Fig. 13: eine schaubildliche Darstellung der Luftdurchtrittseinrichtung mit abgenommenem Ventilatorgehäuse,
- Fig. 14: eine schaubildliche Explosionsdarstellung der Luftdurchtrittseinrichtung gemäß Fig. 13, jedoch bei abgenommenem EMV-Schirmgitter,
- Fig. 15: eine schaubildliche Explosionsdarstellung der Luftdurchtrittseinrichtung mit den einzelnen Bauteilen, in einer Ansicht von der Ventilatorseite aus, und
- Fig. 16: eine schaubildliche Explosionsdarstellung der Luftdurchtrittseinrichtung mit den einzelnen Bauteilen, in einer Ansicht von dem Designdeckel aus.

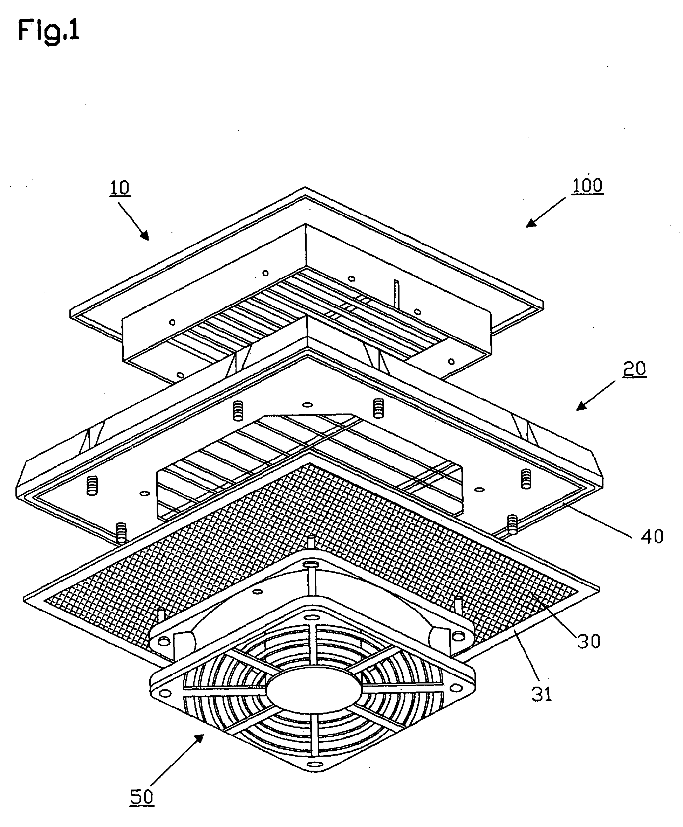

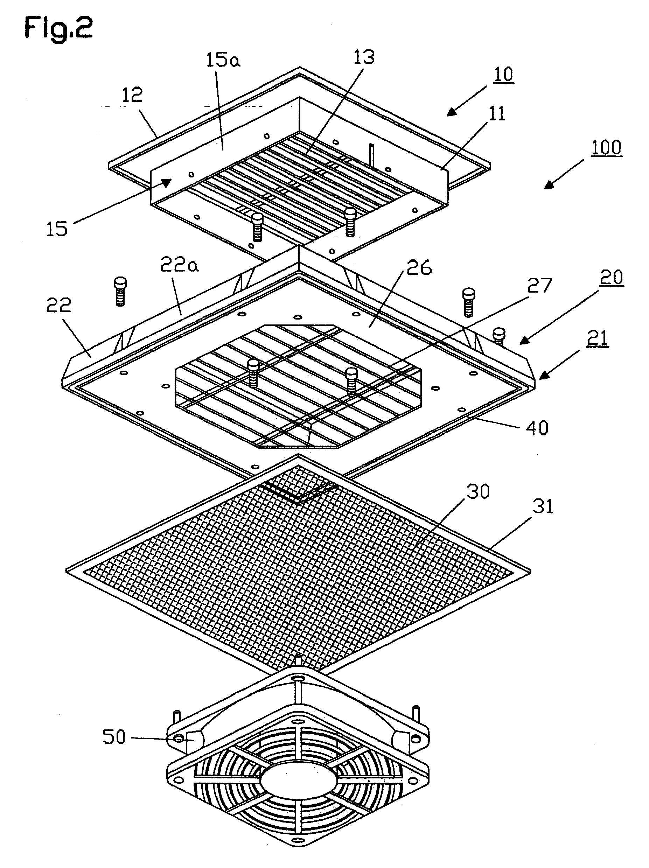

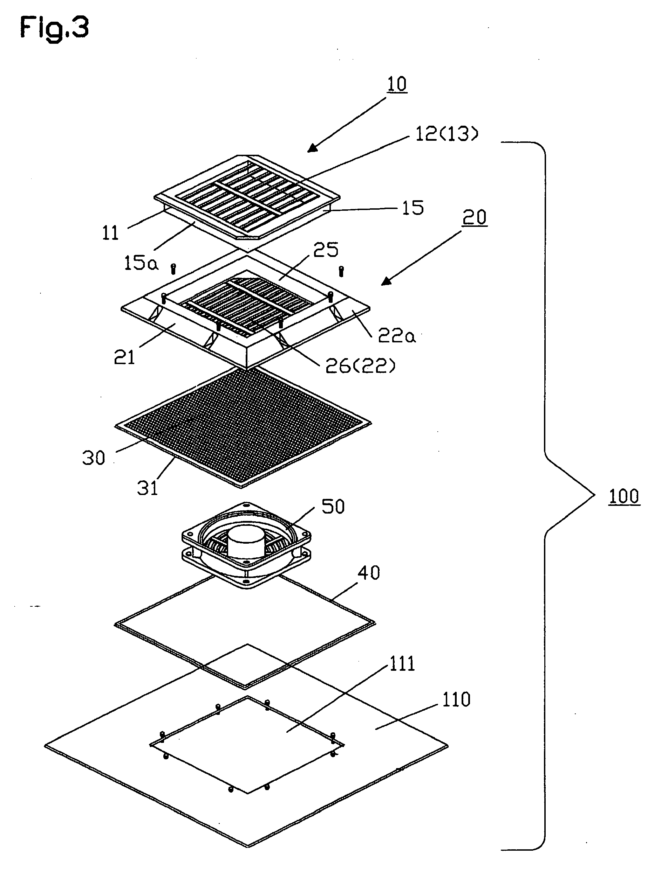

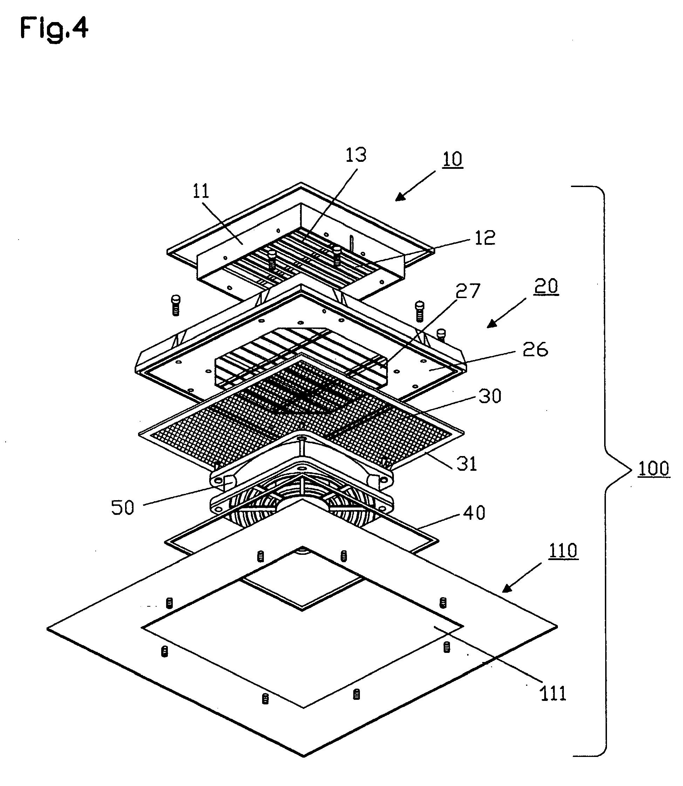

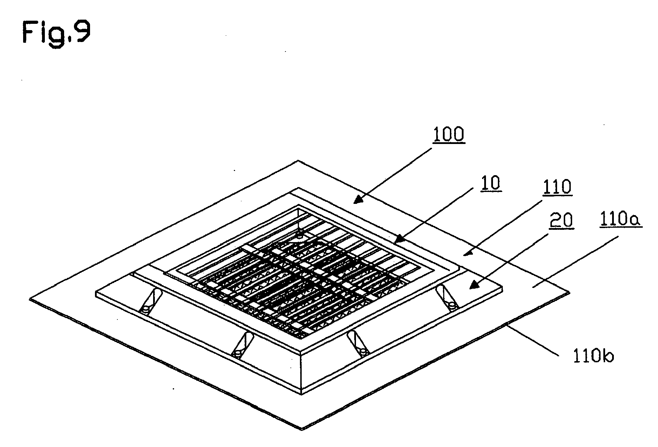

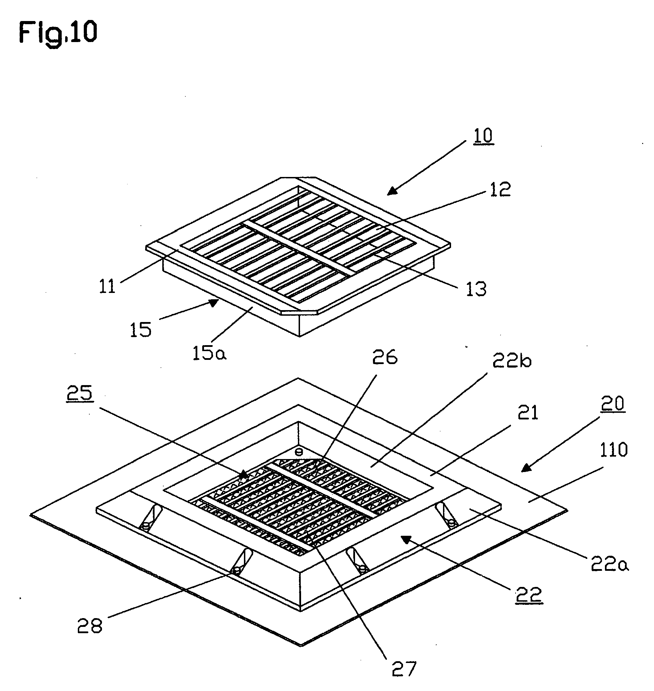

Die erfindungsgemäß ausgebildete Luftdurchtrittseinrichtung 100 gemäß einer ersten Ausführungsform ist in Verbindung mit einem Ventilator 50 als Filterlüfter (Fig. 1 bis 4) und ohne Ventilator 50 als Austrittsfilter einsetzbar (Fig. 9 und 10). Eingesetzt wird die Luftdurchtrittseinrichtung 100 bei Gehäusen von abwärmeerzeugenden Bauteilen, wie Schaltschränke, Elektronikschränke, Computersystem o. dgl., wobei die Luftdurchtrittseinrichtung 100 in Montagedurchbrechungen 111 in einer Wand 110 eines derartigen Gehäuses eingebaut wird (Fig. 3 und 4). Mit 110a ist die Außenwandfläche und mit 110b die Innenwandfläche der Wand 110 des Gehäuses bezeichnet.

Die wesentlichen Bauteile der Luftdurchtrittseinrichtung 100 sind ein Lüftungsgitter 10, ein Trägerkörper 20, ein Schirmgitter 30 mit EMV-Dichtung 31, einer aufgeschäumten IP-Dichtung 40 und dem Ventilator 50, wenn die Luftdurchtrittseinrichtung 100 als Filterlüfter eingesetzt wird (Fig. 1, 2 und 8).

Das Lüftungsgitter 10 besteht aus einem Rahmen 11 mit einer mit Lamellen und/oder Luftschlitzen 13 versehenen Frontplatte 12 und einer halsartigen Einziehung 15 (Fig. 1, 2, 3, 5 und 8), die ein Filtermedium, z. B. Filtermatte oder Filtervlies, aufnimmt und deren umlaufende Wand mit 15a bezeichnet ist.

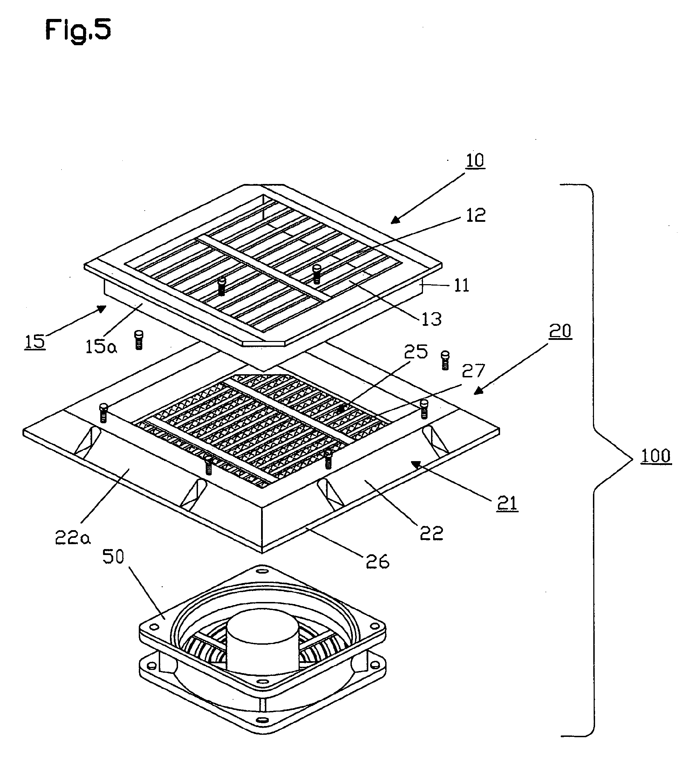

Der Trägerkörper 20 besteht aus einem Rahmen 21 mit einer umlaufenden Wand 22, deren umlaufende Außenwandfläche 22a sich nach außen hin keilförmig erweitert, jedoch auch eine andersartig ausgebildete Wandfläche haben kann. Die umlaufende Wand 22 des Rahmens 21 begrenzt mit ihrer Innenwandfläche 22b einen Innenraum 25 der zur Aufnahme der halsartigen Einziehung 15 des Lüftungsgitters 10 dient (Fig. 5, 9 und 10) mit oder ohne Filtermedium.

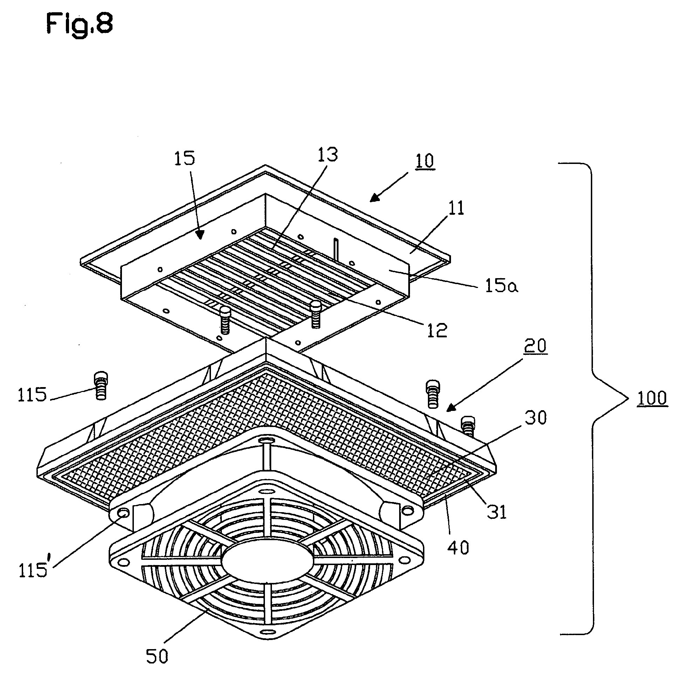

Die Abmessungen und die Formgebung des Innenraumes 25 des Trägerkörpers 20 sind entsprechend der Formgebung und den Abmessungen der halsartigen Einziehung 15 des Rahmens 11 des Lüftungsgitters 10 bemessen, damit das Lüftungsgitter 10 mit seiner halsartigen Einziehung 15 in den Innenraum 25 des Trägerkörpers 20 einsetzbar ist (Fig. 8 und 9).

In der Außenwandfläche 22a der umlaufenden Wand 22 des Trägerkörpers 20 sind Durchbohrungen 28 für Befestigungsschrauben oder andersartig ausgebildete Befestigungsmittel, wie z. B. durchdrückbare Clips, vorgesehen (Fig. 10). Auch andere Befestigungsarten können zum Einsatz kommen.

Die Wandfläche 26 des Rahmens 21 des Trägerkörpers 20 ist mit Luftdurchtrittsöffnungen 27 und mit Wasserableitstegen oder einer Rippenformung zum Ableiten von eingedrungenem Spritzwasser und Kondenswasser versehen (Fig. 10) bzw. wird die Wand 26 von Wasserableitstegen und Luftdurchtrittsöffnungen gebildet.

Der Trägerkörper 20 dient zur Aufnahme der halsartigen Einziehung 15 des Lüftungsgitters 10, das wiederum das in der Zeichnung nicht dargestellte Filtermedium aufnimmt.

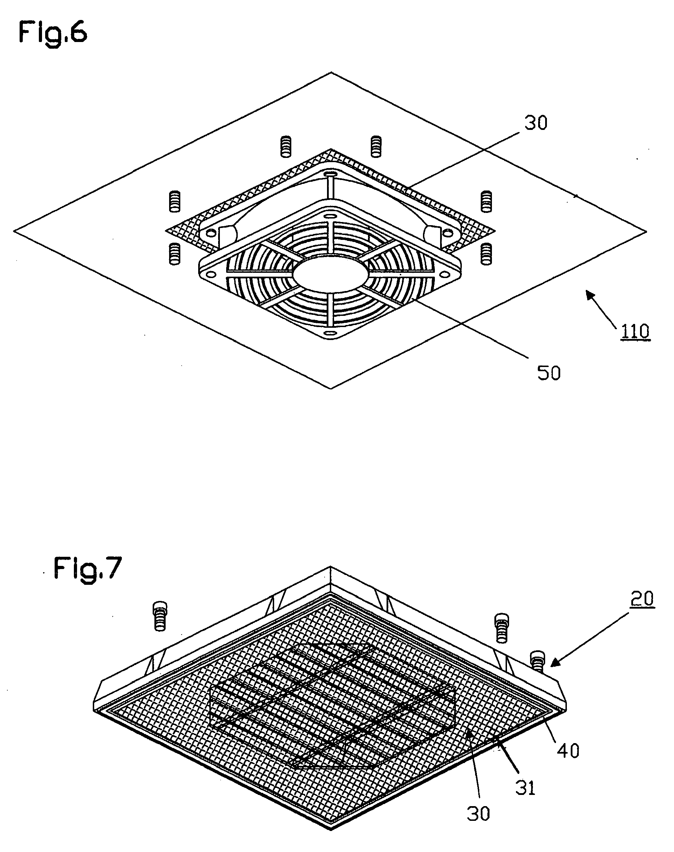

Das Schirmgitter 30, das von unten in den Rahmen 21 des Trägerkörpers 20 eingesetzt oder von unten gegen die Wandplatte 26 des Trägerkörpers 20 gesetzt wird, ist mit einer EMV-Dichtung versehen. Das Schirmgitter 30 übernimmt die Aufgabe der EMV-Dämpfung und wird in den Trägerkörper 20 eingelegt oder an diesen angesetzt (Fig. 7).

Zur Aufnahme des Schirmgitters 30 ist die umlaufende Wand 22 des Rahmens 21 gegenüber der Wandfläche 26 auskragend ausgebildet, so dass das eingesetzte Schirmgitter 30 mit seiner EMV-Dichtung 31 von diesem auskragenden Wandabschnitt seitlich umschlossen und gehalten ist (Fig. 7). Damit das Schirmgitter 30 nicht aus dem Trägerkörper 20 herausfallen kann, wird das Schirmgitter 30 durch eine entsprechende Befestigung gehalten, wobei sich Schraub- oder Nietverbindungen anbieten, jedoch auch andere-Befestigungsmittel können zum Einsatz gelangen, ebenso Klemm- oder Rastverbindungen (Fig. 8). Der umlaufende Rand des Trägerkörpers 20 kann mit einer umlaufenden Nut versehen sein, in der die Schäumung 40 angeordnet ist.

Das Schirmgitter 30 ist in den Trägerkörper 20 an der dem Lüftungsgitter 10 abgekehrten Seite eingesetzt. Die Schrauben 115', die den Ventilator 50 an dem Trägerkörper 20 halten, fixieren auch gleichzeitig das Schirmgitter 30 (Fig. 8). Die Befestigung des Ventilators 50 kann beispielsweise auch mittels einer Nietung erfolgen. Die Gesamtbefestigung an der Gehäusewand 110 erfolgt mittels der Schrauben 115.

Um einen guten Kontakt mit dem Blech des Gehäuses eines Schaltschrankes zu erreichen, wird eine einfache EMV-Dichtung, z. B. eine Clip-On-Dichtung, auf die Seiten des Schirmgitters 30 bei der Produktion geschoben oder anderweitig mit den Rändern des Schirmgitters 30 in Kontakt gebracht. Es können sowohl selbstklebende als auch nichtselbstklebende Dichtungen verwendet werden. So könnte bevorzugterweise z. B. die Halterung der Dichtung mittels einer Klemmverbindung erreicht werden. Zu berücksichtigen ist dabei, dass der Kunde um die Montagedurchbrechung bzw. Montageausschnitt 111 herum einen Streifen von der Lakkierung des Schaltschrankes entfernt z. B. abschmirgelt.

Zum Schutz vor Spritz- und Strahlwasser ist des weiteren eine aufgeschäumte IP-Dichtung 40 vorgesehen, die insbesondere der Erreichung einer hohen IP-Schutzart dient, wobei die IP-Dichtung 40 bevorzugt in eine vorgesehene Nut eingesetzt sein kann (Fig. 3, 4 und 8).

Mit dem Lüftungsgitter 10, dem Trägerkörper 20 und dem Schirmgitter 30 kann der Ventilator 50 direkt verbunden sein (Fig. 8).

Die Befestigung der Bauteile 10, 20, 30, 40 und 50 der Luftdurchtrittseinrichtung 100 erfolgt an der Wand 110 des Gehäuses eines Schaltschrankes mittels Verschraubung oder anderer Befestigungsmittel von außen (Fig. 3).

Nach einer weiteren Ausführungsform kann an der Außenwandfläche 110a der Wand 110 des Gehäuses die Luftdurchtrittseinrichtung 100 mit dem Lüftungsgitter 10 und dem Trägerkörper 20 und an der Innenwandfläche 110b der Wand 110 des Gehäuses das Schirmgitter 30 mit dem Ventilator 50 angeordnet sein.

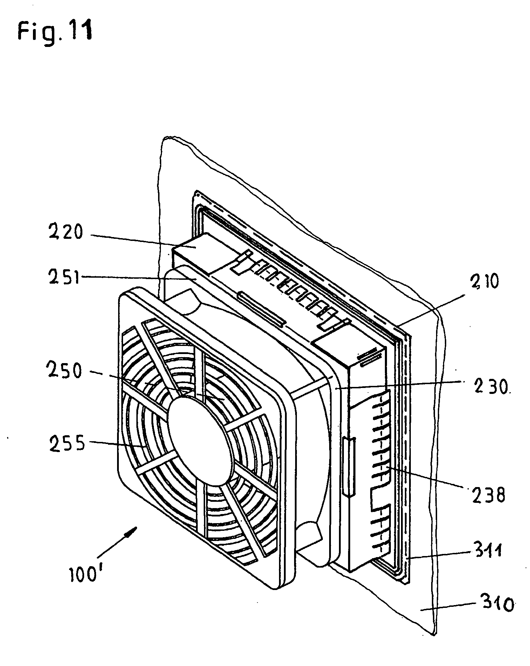

Eine weitere Ausführungsform sieht eine Luftdurchtrittseinrichtung 100' vor, die in Verbindung mit einem Ventilator 250 als Filterlüfter und ohne Ventilator als Austrittsfilter einsetzbar ist. Eingesetzt wird die Luftdurchtrittseinrichtung 100' bei Gehäusen von Abwärme erzeugenden Bauteilen, wie Schaltschränke, Elektronikschränke, Computersysteme o. dgl., wobei die Luftdurchtrittseinrichtung 100' in Montagedurchbrechungen 311 in einer Wand 310 eines derartigen Gehäuses eingebaut wird (Fig. 11).

Die wesentlichen Bauteile der Luftdurchtrittseinrichtung 100' sind in etwa in Übereinstimmung mit der Luftdurchtrittseinrichtung 100 ein Designdeckel 210, ein Grundgehäuse 220, ein EMV-Schirmblech 230 und dem Ventilator 250, wenn der Luftdurchtrittseinrichtung 100' als Filterlüfter eingesetzt wird (Fig. 11, 12, 15 und 16).

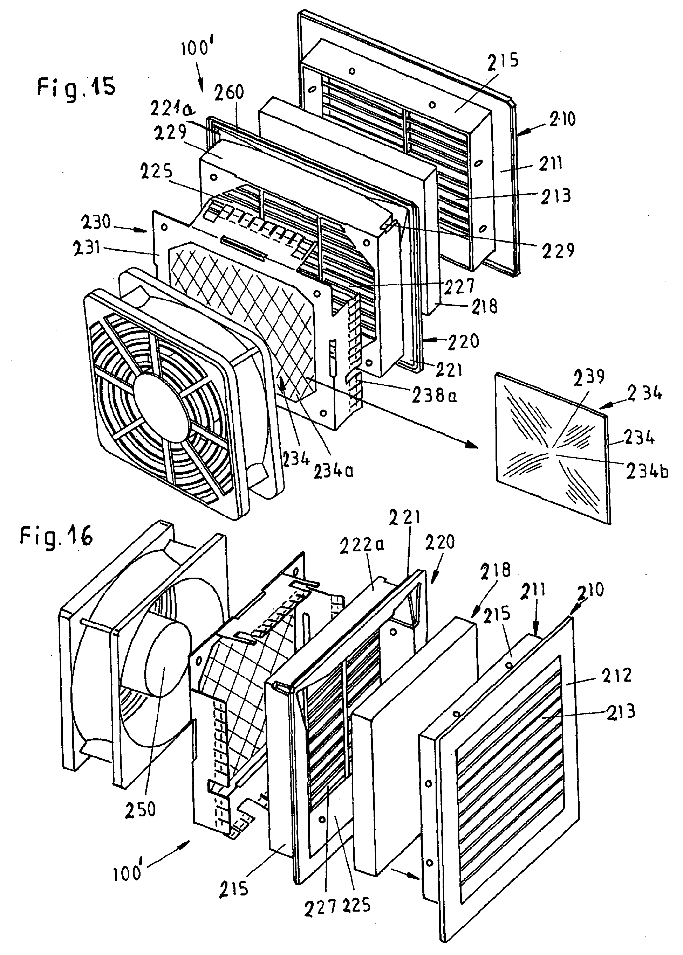

Der Designdeckel 210 besteht aus einem Rahmen 211 mit einer mit Lamellen und/oder Luftschlitzen 213 versehenen Frontplatte 212 und einer halsartigen Einziehung 215 (Fig. 15 und 16).

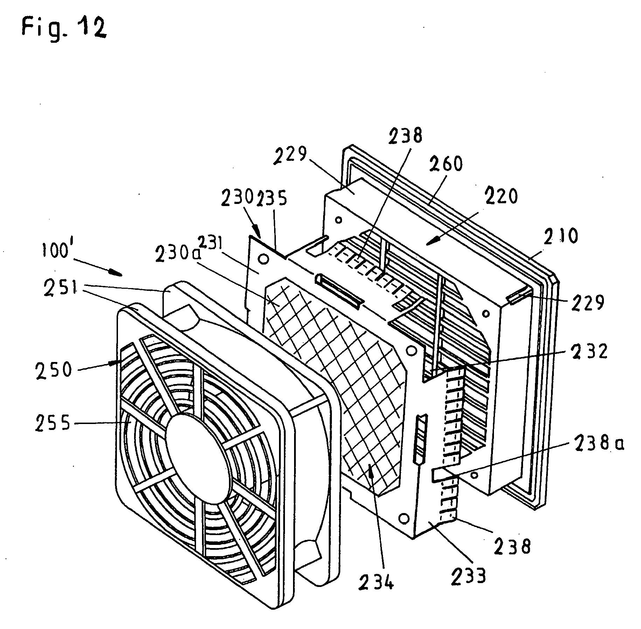

Der Raum, der von der halsartigen Einziehung 215 des Designdeckels 210 gebildet wird, dient zur Aufnahme für ein raumfüllendes Filtermedium 218, das in den von dem Rahmen 211 begrenzten Raum eingesetzt wird (Fig. 12).

Das Grundgehäuse 220 besteht ebenfalls aus einem Rahmen 221 mit einer umlaufenden Wandfläche 222a und mit einem Innenraum 225 zur Aufnahme der halsartigen Einziehung 215 des Designdeckels 210, so dass der Designdeckel 210 mit seiner halsartigen Einziehung 215 in den Innenraum 225 des Rahmens 221 des Grundgehäuses 220 einsetzbar ist und mit diesem verrastet. Das Grundgehäuse 220 ist an seiner dem Designdeckel 210 abgewandten und die Rückwand bildenden Seite mit Luftdurchtrittsöffnungen 227 und an seiner dem Designdeckel 210 zugekehrten Seite mit einer umlaufenden Dichtung 260, z. B. IP-Dichtung, versehen. Diese Dichtung 260 ist an dem Grundgehäuse 220 an der dem Designdeckel 210 abgewandten Seite des auskragenden, umlaufenden Randes 221 a des Grundgehäuses 220 angeordnet. Die Dichtung 260 kann in das Grundgehäusematerial integriert sein, jedoch besteht auch die Möglichkeit, im Bereich des umlaufenden Randes 221a des Grundgehäuses 220 eine umlaufende Nut auszubilden, in die die Dichtung 260 eingesetzt ist.

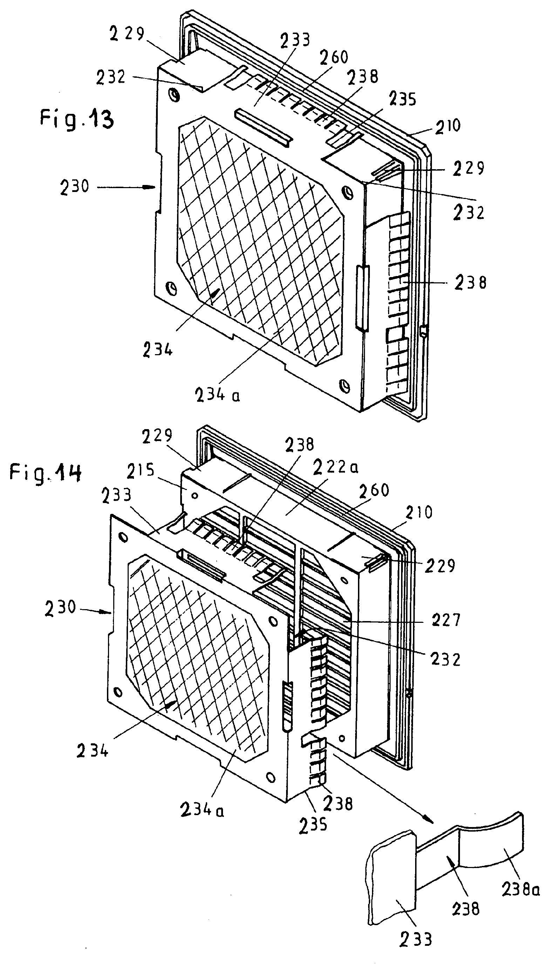

Des weiteren weist das Grundgehäuse 220 mindestens zwei Verriegelungsecken 229 auf, vermittels der eine Schnellbefestigung der Luftdurchtrittseinrichtung 210 in der Montagedurchbrechung 311 in der Wand 310 z. B. eines Schaltschrankes erfolgt. Jedoch auch andersartig ausgebildete Befestigungsmittel können zum Einsatz gelangen (Fig. 13 und 14).

Des weiteren umfasst die Luftdurchtrittseinrichtung 100' ein EMV-Schirmblech 230, das aus einem Metallrahmen 231 mit einer umlaufenden in den Eckbereichen Aussparungen 232 für die Verriegelungsecken 229 des Grundgehäuses 220 aufweisenden Seitenwand 233 und mit einer als Schirmgitter 234 ausgebildeten Rückwand 234a, wobei die dem Grundgehäuse 220 zugewandten Randkanten 235 der umlaufenden Seitenwand 233 des Metallrahmens 231 zur Herstellung einer elektrisch leitfähigen Verbindung zwischen dem EMV-Schirmblech 230 und der Montagedurchbrechung 311 eines Schaltschrankes eine Anzahl von federnden Kontaktzungen 238 aufweisen (Fig. 11 und 12). Diese metallischen federnden Kontaktzungen 238 weisen aus der von der umlaufenden Seitenwand 233 des Metallrahmens 231 gebildeten Ebene seitlich herausgestellte Endabschnitte 238a auf (Fig. 14). Diese Kontaktzungen 238 sind beispielsweise an dem Metallrahmen 231 befestigt oder sind aus der umlaufenden Seitenwand 233 des Metallrahmens 231 herausgeschnitten und so gebogen, dass kontaktzungenartige Leisten erhalten werden (Fig. 12). Alle Bauteile der Luftdurchtrittseinrichtung 100' sind mittels Klemm- oder Schraubverbindung zusammengehalten. Für die Montage der Luftdurchtrittseinrichtung 100' im Bereich der Montagedurchbrechung 311 wird das Grundgehäuse 220 mit seinen Seitenwänden 222a auf die Außenwandfläche der Wand des Schaltschrankes aufgesetzt und mit dieser bevorzugterweise lösbar verbunden.

Mit dem Designdeckel 210, dem Grundgehäuse 220 und dem EMV-Schirmblech 230 ist ein Ventilatorgehäuse 251 mit dem Ventilator 250 verbunden, wobei das Ventilatorgehäuse 251 mit einem außenliegenden Berührungsschutzgitter 255 verbunden sein kann (Fig. 11 und 12).

Die Befestigung der Bauteile 210, 220, 230 250 bzw. 251 der Luftdurchtrittseinrichtung 100' an dem Designdeckel 210 erfolgt mittels Verschraubung oder andersartig ausgebildeter Befestigungsmittel.

Alle Bauteile 210, 220, 251 der Luftdurchtrittseinrichtung 100' bestehen bis auf das EMV-Schirmblech 230 aus einem Kunststoff, jedoch können diese Bauteile auch aus anderen Werkstoffen hergestellt sein.

Das Schirmgitter 234 des EMV-Schirmbleches 230 kann zur Ausbildung einer mittigen Vertiefung 239 mit von seinem umlaufenden Rand 234a zur Schirmgittermitte 234b geneigt verlaufenden Flächen versehen sein (Fig. 15).

## Patentansprüche

1. Luftdurchtrittseinrichtung, insbesondere Filterlüfter oder Austrittsfilter mit einem Ventilator (50) oder ohne Ventilator (50) für den Einbau in eine Montagedurchbrechung (111) in einer Wand (110), insbesondere eines Gehäuses von Abwärme erzeugenden Bauteilen, wie Schaltschrank, Elektronikschrank, Computersystem od. dgl.,
**dadurch gekennzeichnet,**
**dass** die Luftdurchtrittseinrichtung (100)
- ein Lüftungsgitter (10), das aus einem Rahmen (11) mit einer mit Lamellen und/oder Luftschlitzen (13) versehenen Frontplatte (12) und einer halsartigen Einziehung (15) besteht, wobei der Rahmen (11) ein Filtermedium aufnimmt,
- einen Trägerkörper (20), der aus einem Rahmen (21) mit einer vorzugsweise keilförmig sich nach außen erweiternden umlaufenden Wandfläche (22a) und mit einem Innenraum (25) zur Aufnahme der halsartigen Einziehung (15) des Lüftungsgitters (10) besteht, wobei der Trägerkörper (20) an seiner dem Lüftungsgitter (10) abgewandten Seite mit Luftdurchtrittsöffnungen (27) und mit Wasserableitstegen oder einer Rippenformung zum Ableiten von eingedrungenem Spritzwasser und Kondenswasser versehen ist und zur Aufnahme der halsartigen Einziehung (15) des Lüftungsgitters (10) dient,
- ein Schirmgitter (30) mit einer EMV-Dichtung (31) oder mit einem EMV-Schirmblech (230) mit einer Anzahl von federnden Kontaktzungen (238) zur EMV-Dämpfung, das in den Trägerkörper (20) an der dem Lüftungsgitter (10) abgekehrten Seite eingesetzt ist, und das mittels Schraub-, Niet-, Kleb- oder Klemmverbindungen an dem Trägerkörper (20) gehalten wird, und
- eine auf den Trägerkörper (20) aufgeschäumte IP-Dichtung (40) zum Schutz vor Spritz- und Strahlwasser umfasst,
wobei alle Bauteile der Luftdurchtrittseinrichtung (100) mittels Klemm- oder Schraubverbindungen zusammengehalten sind.

2. Luftdurchtrittseinrichtung nach Anspruch 1,
**dadurch gekennzeichnet,**
**dass** die Luftdurchtrittseinrichtung (100')
- ein als Designdeckel (210) ausgebildetes Lüftungsgitter (10), wobei der Designdeckel (210) der aus einem Rahmen (211) mit einer mit Lamellen und/oder Luftschlitzen (213) versehenen Frontplatte (212) und einer halsartigen Einziehung (215) besteht,
- ein in den von dem Rahmen (211) begrenzten Raum eingesetztes raumfüllendes Filtermedium (218),
- einen als Grundgehäuse (220) ausgebildeten Trägerkörper (20), wobei das Grundgehäuse (220) aus einem Rahmen (221) mit einer umlaufenden Wandfläche (222a) und mit einem Innenraum (225) zur Aufnahme der halsartigen Einziehung (215) des Designdeckels (210) besteht, wobei der Trägerkörper (220) an seiner dem Designdeckel (210) abgewandten die Rückwand bildenden Seite mit Luftdurchtrittsöffnungen (227) und an seiner dem Designdeckel (210) zugekehrten Seite mit einer umlaufenden Dichtung (260) versehen ist, sowie mindestens zwei Verriegelungsecken (229) aufweist,
- ein EMV-Schirmblech (230) aus einem Metallrahmen (231) mit einer umlaufenden, in den Eckbereichen Aussparungen (232) für die Verriegelungsecken (229) des Grundgehäuses (220) aufweisenden Seitenwand (233) und mit einer als Schirmgitter (234) ausgebildeten Rückwand (234a), wobei die dem Grundgehäuse (220) zugewandten Randkanten (235) der umlaufenden Seitenwand (233) des Metallrahmens (231) zur Herstellung einer elektrisch leitfähigen Verbindung zwischen dem EMV-Schirmblech (230) und der Montagedurchbrechung (211) eines Schaltschrankes eine Anzahl von federnden Kontaktzungen (238) aufweisen, die aus der von der umlaufenden Seitenwand (233) des Metallrahmens (231) gebildeten Ebene seitlich herausgestellte Endabschnitte (238a) aufweisen, wobei die Kontaktzungen (238) an dem Metallrahmen (231) angepunktet oder aus der umlaufenden Seitenwand (233) des Metallrahmens (231) herausgeschnitten sind, umfasst,
wobei alle Bauteile der Luftdurchtrittseinrichtung (100') mittels Klemm- oder Schraubverbindungen zusammengehalten sind.

3. Luftdurchtrittseinrichtung nach Anspruch 1,
**dadurch gekennzeichnet,**
**dass** mit dem Lüftungsgitter (10), dem Trägerkörpers (20) und dem Schirmgitter (30) ein Ventilator (50) verbunden ist.

4. Luftdurchtrittseinrichtung nach Anspruch 2,
**dadurch gekennzeichnet,**
**dass** mit dem Designdeckel (210), dem Grundhäuse (220) und dem EMV-Schirmblech (230) ein Ventilatorgehäuse (251) mit einem Ventilator (250) und mit einem außenliegenden Berührungsschutzgitter (255) verbunden ist.

5. Luftdurchtrittseinrichtung nach einem der Ansprüche 1 bis 4,
**dadurch gekennzeichnet,**
**dass** zur Kontaktverbesserung des Schirmgitters (30) eine EMV-Dichtung, wie z. B. eine Clip-On-Dichtung, oder ein andersartig ausgebildetes Material eingesetzt wird.

6. Luftdurchtrittseinrichtung nach einem der Ansprüche 1 bis 5,
**dadurch gekennzeichnet,**
**dass** die Befestigung der Bauteile (210, 220, 230, 250) der Luftdurchtrittseinrichtung (100') an dem Designdeckel (210) mittels Verschraubung oder andersartig ausgebildeter Befestigungsmittel erfolgt.

7. Luftdurchtrittseinrichtung nach einem der Ansprüche 1 bis 6,
**dadurch gekennzeichnet,**
**dass** alle Bauteile (210, 220, 251) der Luftdurchtrittseinrichtung (100') bis auf das EMV-Schirmblech (230) aus einem Kunststoff besteht.

8. Luftdurchtrittseinrichtung nach einem der Ansprüche 1 bis 7,
**dadurch gekennzeichnet,**
**dass** zwischen dem Ventilatorgehäuse (251) mit dem Ventilator (250) und den übrigen Bauteilen (210, 220, 230) der Luftdurchtrittseinrichtung (100') ein adapterartiger Gebläseträger zur Montage von Ventilatorgehäusen mit größeren oder kleineren Abmessungen gegenüber den Bauteilen (210, 220, 230) der Luftdurchtrittseinrichtung (100') angeordnet ist.

9. Luftdurchtrittseinrichtung nach einem der Ansprüche 1 bis 8,
**dadurch gekennzeichnet,**
**dass** die Dichtung (260) an dem Grundgehäuse (220) an der dem Designdeckel (210) abgewandten Seite des auskragenden, umlaufenden Randes (221a) des Grundgehäuses (220) angeordnet und in das Grundgehäusematerial integriert ist bzw. in eine umlaufende Nut eingesetzt ist.

10. Luftdurchtrittseinrichtung nach einem der Ansprüche 1 bis 9,
**dadurch gekennzeichnet,**
**dass** das Schirmgitter (234) des EMV-Schirmbleches (230) zur Ausbildung einer mittigen Vertiefung (239) mit von seinem umlaufenden Rand (234a) zur Schirmgittermitte (234b) geneigt verlaufenden Flächen versehen ist.

## Claims

1. Device for the passage of air, in particular filter fan or outlet filter, with a fan (50) or without fan (50) for fitting into a mounting opening (111) in a wall (110), in particular of a casing of waste heat producing components such as of a switch cupboard, of an electronic cupboard, of a computer system or the like,
**characterized in**
**that** the device for the passage of air (100) comprises
- a ventilation grid (10) which consists of a frame (11) with a front plate (12) provided with lamellae and/or air slits (13) and a neck-type recess (15), whereby the frame (11) receives a filtering agent,
- a supporting body (20) which consists of a frame (21) with a preferably wedge-shaped enlarging peripheral wall surface (22a) and with an inner space (25) for receiving the neck-type recess (15) of the ventilation grid (10), whereby the supporting body (20) is provided on its side opposite to the ventilation grid (10) with openings for the passage of air (27) and with water drain ridges or with a rib formation for draining penetrated splash water and condensation water and serves for receiving the neck-type recess (15) of the ventilation grid (10),
- a screen grid (30) with an EMC gasket (31) or with an EMC shroud (230) with a number of resilient contact studs (238) for the EMC damping which is placed in the supporting body (20) on the side opposite to the ventilation grid (10) and which is held by means of screwed, riveted, glued or clamping connections on the suporting body (20) and
- an IP gasket (40) foamed onto the supporting body (20) for the protection from splash water and jet water, whereby all the components of the device for the passage of air (100) are held together by means of clamping or screwing connections.

2. Device for the passage of air according to claim 1,
**characterized in**
**that** the device for the passage of air (100') comprises
- a ventilation grid (10) configured as design cover (210), whereby the design cover (210) consists of a frame (211) with a front plate (212) provided with lamellae and/or air slits (213) and of a neck-type recess (215),
- a filter agent (218) placed in the space limited by the frame (211) and filling this space,
- a supporting body (20) configured as main casing (220), whereby the main casing (220) consists of a frame (221) with a peripheral wall surface (222a) and with an inner space (225) for receiving the neck-type recess (215) of the design cover (210), whereby the supporting body (220) is provided with openings for the passage of air (227) on its side opposite to the design cover (21) which forms the rear wall and with a peripheral gasket (260) on its side turned to the design cover (210) and has at least two locking corners (229),
- an EMC shroud (230) made of a metallic frame (231) with a peripheral side wall (233) which has recesses (232) in the corner areas for the locking corners (229) of the main casing (220) and with a rear wall (234a) configured as a screen grid (234), whereby the boundary edges (235) of the peripheral side wall (233) of the metallic frame (231) which are turned to the main casing (220) have, for producing an electrically conductive connection between the EMC shroud (230) and the mounting opening (211) of a switch cupboard, a number of resilient contact studs (238) which have laterally projecting end portions (238a) out of the surface plane formed by the peripheral side wall (233) of the metallic frame (231), whereby the contact studs (238) are fixed by points to the metallic frame (231) or are cut out from the peripheral side wall (233) of the metallic frame (231),
whereby all the components of the device for the passage of air (100') are held together by means of clamping or screwing connections.

3. Device for the passage of air according to claim 1,
**characterized in**
**that** a fan (50) is connected with the ventilation grid (10), the supporting body (20) and the screen grid (30).

4. Device for the passage of air according to claim 2,
**characterized in**
**that** a fan casing (251) with a fan (250) and with an outer safety grid (255) is connected with the design cover (210, the main casing (220) and the EMC shroud (230).

5. Device for the passage of air according to any of the claims 1 to 4,
**characterized in**
**that** an EMC gasket such as, for example a clip-on seal, or a material of a different configuration is set in for improving the contact of the screen grid (30).

6. Device for the passage of air according to any of the claims 1 to 5,
**characterized in**
**that** the fixing of the components (210, 220, 230, 250) of the device for the passage of air (100') on the design cover (210) is made by a screwed connection or by a fixing means of a different configuration.

7. Device for the passage of air according to any of the claims 1 to 6,
**characterized in**
**that** all the components (210, 220, 251) of the device for the passage of air (100') are made of a synthetic material except the EMC screen grid (230).

8. Device for the passage of air according to any of the claims 1 to 7,
**characterized in**
**that** an adapter-type blast support is placed between the fan casing (251) with the fan (250) and the other components (210, 220, 230) of the device for the passage of air (100') for mounting fan casings with bigger or smaller dimensions with respect to the components (210, 220, 230) of the device for the passage of air (100').

9. Device for the passage of air according to any of the claims 1 to 8,
**characterized in**
**that** the seal (260) on the main casing (220) is placed on the side of the projecting peripheral edge (221 a) of the main casing (220) which is opposite to the design cover (210) and is integrated into the main casing material or inserted into a peripheral groove.

10. Device for the passage of air according to any of the claims 1 to 9,
**characterized in**
**that** the screen grid (234) of the EMC shroud (230) is provided, for forming a central deepening (239), with surfaces inclined from its peripheral edge (234a) to the screen grid middle (234b).

## Revendications

1. Dispositif de passage d'air, en particulier aérateur à filtre ou filtre de sortie avec un ventilateur (50) ou sans ventilateur (50), pour le montage dans une découpure de montage (111) dans une paroi (110), en particulier d'un boîtier de composants produisant de la chaleur perdue comme d'une armoire de commande, d'une armoire électronique, d'un système d'ordinateur ou équivalent,
**caractérisé en ce**
**que** le dispositif de passage d'air (100) comprend
- une grille d'aération (10) qui est constituée par un cadre (11) avec une plaque frontale (12) pourvue de lamelles et/ou de fentes d'aération (13) et un rétrécissement de type gorge (15), le cadre (11) logeant un agent filtrant,
- un corps de support (20) qui est constitué par un cadre (21) avec une surface de paroi périphérique (22a) qui s'élargit de préférence en clavette vers l'extérieur et avec un espace intérieur (25) pour le logement du rétrécissement de type gorge (15) de la grille d'aération (10), le corps de support (20) étant pourvu, sur son côté opposé à la grille d'aération (10), d'ouvertures de passage de l'air (27) et de barrettes de dérivation de l'eau ou d'une formation de nervures pour dériver de l'eau projetée et de l'eau de condensation qui a pénétré, et qui sert à loger le rétrécissement de type gorge (15) de la grille d'aération (10),
- une grille-écran (30) avec une étanchéité CEM (31) ou avec une tôle de protection CEM (230) avec un certain nombre de languettes de contact élastiques (238) pour l'amortissement CEM qui est mise en place dans le corps de support (20) sur le côté opposé à la grille d'aération (10) et qui est maintenue sur le corps de support (20) au moyen de vissages, rivetages, collages ou serrages et
- une étanchéité IP (40) moussée sur le corps de support (20) pour la protection de l'eau projetée et des jets d'eau,
tous les composants du dispositif de passage de l'air (100) étant maintenus ensemble par des serrages ou des vissages.

2. Dispositif de passage d'air selon la revendication 1,
**caractérisé en ce**
**que** le dispositif de passage d'air (100') comprend
- une grille d'aération (10) configurée comme un couvercle design (210), le couvercle design (210) étant constitué par un cadre (211) avec une plaque frontale (212) pourvue de lamelles et/ou de fentes d'air (213) et avec un rétrécissement de type gorge (215),
- un agent de filtrage (218) qui est placé dans l'espace limité par le cadre (211) et qui remplit cet espace,
- un corps de support (20) configuré comme boîtier de base (220), le boîtier de base (220) étant constitué par un cadre (221) avec une surface de paroi périphérique (222a) et avec un espace intérieur (225) pour le logement du rétrécissement de type gorge (215) du couvercle design (210), le corps de support (220) étant pourvu, son son côté opposé au couvercle design (210) et qui forme la paroi arrière, d'ouvertures de passage d'air (227) et, sur son côté tourné vers le couvercle design (210), d'une étanchéité périphérique (260), et présentant au moins deux coins de verrouillage (229),
- une tôle de protection CEM (230) constituée par un cadre métallique (231) avec une paroi latérale périphérique (233) qui présente dans les zones de coin des réservations (232) pour les coins de verrouillage (229) du bâti de base (220) et avec une paroi arrière (234a) configurée comme tôle de protection (234), les arêtes marginales (235) de la paroi latérale périphérique (233) du cadre métallique (231) qui sont tournées vers le bâti de base (220) présentant, pour réaliser une jonction élecroconductrice entre la tôle de protection CEM (230) et la découpure de montage (211) d'une armoire de commande, un certain nombre de languettes de contact élastiques (238) qui présentent des portions d'extrémité (238a) qui sortent latéralement (238a) du plan formé par la paroi latérale périphérique (233) du cadre métallique (231), les languettes de contact (238) étant fixées par des points au cadre métallique (231) ou étant découpées dans la paroi latérale périphérique (233) du cadre métallique (231),
tous les composants du dispositif de passage de l'air (100') étant maintenus ensemble par des serrages ou des vissages.

3. Dispositif de passage d'air selon la revendication 1,
**caractérisé en ce**
**qu'**un ventilateur (50) est relié à la grille d'aération (10), au corps de support (20) et à la grille-écran (30).

4. Dispositif de passage d'air selon la revendication 2,
**caractérisé en ce**
**qu'**un bâti de ventilateur (251) avec un ventilateur (250) et avec une grille de protection contre les contacts située à l'extérieur (255) est relié au couvercle design (210), au bâti de base (220) et à la tôle de protection CEM (230).

5. Dispositif de passage d'air selon l'une des revendications 1 à 4,
**caractérisé en ce**
**qu'**une étanchéité CEM, comme par exemple une étanchéité clipsable ou un matériau configuré d'un autre type, est mise en place pour améliorer le contact de la grille de protection (30).

6. Dispositif de passage d'air selon l'une des revendications 1 à 5,
**caractérisé en ce**
**que** la fixation des composants (210, 220, 230, 250) du dispositif de passage d'air (100') se fait sur le couvercle design (210) au moyen d'un vissage ou d'un moyen de fixation configuré d'un autre type.

7. Dispositif de passage d'air selon l'une des revendications 1 à 6,
**caractérisé en ce**
**que** tous les composants (210, 220, 251) du dispositif de passage d'air (100') sont en une matière synthétique à l'exception de la tôle de protection CEM (230).

8. Dispositif de passage d'air selon l'une des revendications 1 à 7,
**caractérisé en ce**
**qu'**un support de soufflante de type adaptateur est placé entre le boîtier du ventilateur (251) avec le ventilateur (250) et les autres constituants (210, 220, 230) du dispositif de passage d'air (100') pour le montage de boîtiers de ventilateurs avec des dimensions plus grandes ou plus petites par rapport aux composants (210, 220, 230) du dispositif de passage d'air (100').

9. Dispositif de passage d'air selon l'une des revendications 1 à 8,
**caractérisé en ce**
**que** l'étanchéité (260) est placée sur le boîtier de base (220) sur le côté du bord périphérique en saillie (221a) du boîtier de base (220) qui est opposé au couvercle design (210) et est intégrée au matériau du boîtier de base ou est mise en place dans une rainure périphérique.

10. Dispositif de passage d'air selon l'une des revendications 1 à 9,
**caractérisé en ce**
**que** la grille de protection (234) de la tôle de protection CEM (230) est pourvue, pour configurer un approfondissement central (239), de surfaces inclinées à partir de son bord périphérique (234a) vers le milieu de la grille de protection (234b).
